# EUROPEAN PATENT SPECIFICATION

(11) **EP 4 427 115 B1**
(45) Date of publication and mention of the grant of the patent: **08.07.2026**
(21) Application number: 21968502.1
(22) Date of filing: 21.12.2021
(51) Int. Cl.: G06F 1/18, G06F 1/184, G06F 1/20

(54) **INDUSTRIAL PERSONAL COMPUTER**
INDUSTRIELLER PERSONALRECHNER
ORDINATEUR PERSONNEL INDUSTRIEL

(43) Date of publication of application: 11.09.2024
(73) Proprietor: Siemens Aktiengesellschaft, 80333 München (DE)
(72) Inventor: LIN, Shi Kong, Chengdu, Sichuan 610057 (CN); LAN, Ting Li, Chengdu, Sichuan 610066 (CN)
(74) Representative: Isarpatent
(86) International application number: PCT/CN2021/140170
(87) International publication number: WO 2023/115351

(56) References cited:
- EP-A1- 1 591 871
- EP-B1- 1 333 359
- CN-A- 102 858 136
- CN-A- 105 759 923
- CN-U- 206 833 330
- US-A- 5 436 794
- US-A1- 2008 316 706
- US-A1- 2016 299 545
- US-A1- 2020 174 534

## Description

### Technical Field

The present disclosure relates to an industrial personal computer (industrial PC or IPC or industrial computer), in particular to an industrial personal computer with improved SSD heat dissipation.

### Background Art

With rapid development of computer and automation technology, industrial PCs have been widely used as terminal platforms in more and more key industries, due to their stable working status, rich interface extensions and strong adaptability to harsh working environments.

Often deployed in the harsh working environments with, for example, high temperature, high humidity and lots of dust, most of the traditional industrial PCs use a general industrial motherboard with various functional electronic components mounted thereon, and an aluminum (Al) housing defines an interior in which the motherboard and the electronic components are accommodated. The Al housing or a portion thereof functions as a main heat dissipating member or cooling member for dissipating heat generated by heat generating components, such as a CPU and a SSD. For example, the heat is only dissipated into ambient air via natural convection through the heat dissipating member.

However, with the housing being typically sealed from the dust and due to a fixed motherboard layout in the interior and a limited space between the motherboard and the housing, a large amount of heat generated mainly by the CPU and the SSD can't be dissipated out efficiently, which results in a much higher temperature of the housing than the ambient air. In particular, in conditions where the CPU generates much more heat than the SSD, the SSD has a poor cooling efficiency.

Moreover, taking the working environments and cooling power consumption into consideration, it is impossible or at least difficult to improve the heat dissipation efficiency by cooling down the ambient air around the industrial PCs.

Therefore, using the housing as the only cooling member for both the CPU and the SSD with only natural convection around the industrial PCs, cooling for the SSD between the motherboard and the housing is inadequate and difficult.

It is desired to improve the heat dissipation of the Industrial PCs.

US 2020/174534 A1 discloses an apparatus includes a chassis; a circuit board assembly; and a heat sink assembly. The circuit board assembly includes a component to be removably installed in the connector. The heat sink assembly forms a cover for the chassis. The heat sink assembly includes a first heat sink and a second heat sink. The first heat sink is attached to the chassis, and the first heat sink includes an opening in the cover that corresponds to a location of the component. The second heat sink is to be attached to the first heat sink to close the opening and to be removable from the first heat sink to allow access to the opening to service the component.

CN 206 833 330 U provide a new type of high-performance industrial computer. By using the structure, the utility of the industrial computer is improved, the service rate of the industrial computer is reduced, and the service life of the industrial computer is prolonged.

### Summary of the Disclosure

An object of the disclosure is to address at least one of the above issues.

The object is achieved with a novel industrial personal computer according to the disclosure. The industrial personal computer can comprise: a main housing exposed to ambient air and comprising a top panel and two side panels, the two side panels extending from opposite ends of the top panel in a longitudinal direction to define an inverted-U-shape profile when viewed in a lateral direction perpendicular to the longitudinal direction and define an internal space, at least one panel of the top panel and two side panels being used as a CPU heat dissipating member, and a portion of the one panel being recessed into the internal space to form a pocket; a CPU accommodated in the internal space, heat generated by the CPU being transferred to the CPU heat dissipating member in a CPU heat dissipating path and dissipated directly into the ambient air from the CPU heat dissipating member; a SSD at least partially positioned in the pocket; and a SSD heat dissipating member positioned in the pocket and exposed to the ambient air, heat generated by the SSD being transferred to the SSD heat dissipating member in a SSD heat dissipating path and dissipated directly into the ambient air from the SSD heat dissipating member, wherein the SSD heat dissipating member is heat isolated from the CPU heat dissipating member.

Providing the industrial personal computer with the separate SSD heat dissipating path which is heat isolated from the CPU heat dissipating path and moving the SSD at least partially, preferably entirely, outside of the main housing, the heat dissipation efficiency and cooling effect of the SSD are improved.

In an embodiment, the SSD heat dissipating member can be spaced apart from the CPU heat dissipating member with a gap, or the SSD heat dissipating member and the CPU heat dissipating member can comprise surfaces contacting each other with a heat insulating member interposed between the surfaces and heat isolating them from each other. The SSD heat dissipating member is heat isolated from the CPU heat dissipating member, and thus the negative effect of the CPU heat dissipating member which has a relatively high temperature on the SSD heat dissipating member which has a relatively low temperature can be eliminated or at least minimized.

In an embodiment, the one panel can comprise a panel body, the pocket defining an opening in the panel body of the one panel, and the SSD heat dissipating member being configured to cover the opening. Preferably, the SSD heat dissipating member can comprise a SSD body which is shaped to be complementary to the opening, and more preferably, an outer surface of the SSD body of the SSD heat dissipating member away from the internal space can be flush with is an outer surface of the panel body away from the internal space. In this way, the industrial PC has a good appearance.

In an embodiment, the panel body can define a concave corner extending along the opening and defined by a first corner surface and a second corner surface connected with each other, and the SSD body of the SSD heat dissipating member can define a convex edge adapted to be mated with the concave corner and defined by a first edge surface to be pressed against the first corner surface and a second edge surface to face the second corner surface. In particular, the heat insulating member can be provided between the first edge surface and the first corner surface and the second edge surface and the second corner surface can be spaced apart from each other, or the heat insulating member can be provided between the first edge surface and the first corner surface and between the second edge surface and the second corner surface. As such, the SSD heat dissipating member can be heat isolated from the CPU heat dissipating member. The concave corner can be a right-angled or rounded corner and the convex edge can be right-angle right-angled or rounded edge.

In some embodiments, the opening can extend along an entire width of the one panel in the lateral direction and opens at opposite ends in the lateral direction, or the opening can be a closed opening and shaped to be trapezoidal, triangular, pentagonal, hexagonal rectangular, octagonal, oval, or circular. Therefore, the SSD heat dissipating member can have any shape as desired. Further, the heat insulating member can be in a form of film or coating, and the heat insulating member can be made of glass fiber or asbestos.

In some embodiments, the opening can extend along an entire width of the one panel in the lateral direction and divide CPU top fins extending outwardly from the one panel away from the internal space into a first set of fins and a second set of fins, and the SSD heat dissipating member can comprise SSD fins extending outwardly away from the internal space, and wherein the first set of fins and the second set of fins are symmetrical or asymmetrical with regard to the opening; and/or the CPU top fins and/or the SSD fins each include one or more types of fins, the type of fin being associated with parameters of the fin including an extending direction of the fin, a cross-sectional shape of the fin, a cross-sectional dimension of the fin, a spacing between adjacent fins, the arrangement pattern of the fins. Providing the heat dissipating members with fins can increase a surface area for heat dissipation.

In an embodiment, the industrial personal computer can further comprise a motherboard which is secured to the main housing within the internal space, the CPU being secured to the motherboard, and the motherboard being spaced apart from or in contact with a bottom wall of the pocket closest to the motherboard. The SSD can be secured to a motherboard by means of at least one of a SSD mount which extends through a mount hole formed in the bottom wall of the pocket and a fastener which extends through a fastener hole formed in the bottom wall, the mount hole and the fastener hole being provided as separates holes or a single hole which is sized to receive both the SSD mount and the fastener or to receive at least a portion of the SSD. Alternatively, the SSD can be entirely accommodated in and secured to the pocket with an electrically connecting member extending through the pocket to electrically connect the SSD to an electronic component on the motherboard. Any suitable structure for securing the SSD can be adopted.

In an embodiment, the SSD and a surface of the pocket adjacent to the SSD can be heat isolated from each other by a further heat insulating member interposed therebetween or by a gap separating them apart from each other. Heat isolating the SSD and the CPU heat dissipating member further improves the heat dissipation of the SSD.

The SSD heat dissipating member can be secured to an intermediate component which in turn is secured to the SSD, or the SSD heat dissipating member can be secured to the motherboard with a connecting member which extends through the pocket, or the SSD heat dissipating member can be secured to the CPU heat dissipating member. Any suitable structure of securing the SSD heat dissipating member can be adopted.

Specifically, the SSD heat dissipating member can be secured to the bottom wall and/or a side wall of the pocket connecting the bottom wall with a panel body of the one panel. Optionally, one or more studs can extend from the bottom wall, and the SSD heat dissipating member can be secured to the stud with a fastener.

In an embodiment, the CPU heat dissipating path can further comprise a CPU heat transferring member which is configured to be sandwiched and compressed between the CPU and the main housing so as to transfer the heat from the CPU to the main housing. The SSD heat dissipating path can further comprise a SSD heat transferring member which is configured to be sandwiched and compressed between the SSD and the SSD heat dissipating member so as to transfer the heat from the SSD to the SSD heat dissipating member. The SSD heat transferring member and the CPU heat transferring member can be made of heat conductive elastomer, which facilitates heat transfer between respective heat sources and the heat dissipating members.

In an embodiment, the one panel is the top panel, the top panel and two side panels ca be formed as an integral or formed separately and attached to each other, and the entire main housing can be used as the CPU heat dissipating member.

The industrial personal computer configured according to the disclosure achieves improved heat dissipation and better cooling effect without compromise of an outer appearance thereof. In particular, separate CPU and SSD heat dissipating paths are provided which are heat isolated from each other, the heat generated by the CPU and the SSD can be dissipated into the ambient air independently and efficiently, and therefore both the CPU and the SSD can be cooled down adequately. Providing the SSD at least partially outside of the main housing is further advantageous for heat dissipation of the SSD.

Meanwhile, both the SSD heat dissipating member of the SSD heat dissipating path which is exposed to the ambient air and the CPU heat dissipating member of the CPU heat dissipating path which is exposed to the ambient air are portions of the main housing of the industrial personal computer, which provides the industrial personal computer with an aesthetically perfect appearance.

### Brief Description of the Drawings

The foregoing summary, as well as the following detailed description of an example embodiment of the application, will be better understood when read in conjunction with the appended drawings, in which there is shown the example embodiment for the purposes of illustration. It should be understood, however, that the application is not limited to the precise arrangements shown. In the drawings:
FIG. 1 is an assembled view illustrating an industrial personal computer (industrial PC) according to an example embodiment of the disclosure;
FIG. 2 is an exploded view of the industrial PC in FIG. 1 in which some of internal components are shown;
FIG. 3 is a bottom view of the industrial PC of FIG. 1;
FIG. 4 is a cross-sectional view of the industrial PC taken along a line B-B in FIG. 3;
FIG. 5 is a top view of the industrial PC of FIG. 1; and
FIG. 6 is a cross-sectional view of the industrial PC taken along a line C-C in FIG. 5.

### Detailed Description of Preferred Embodiments

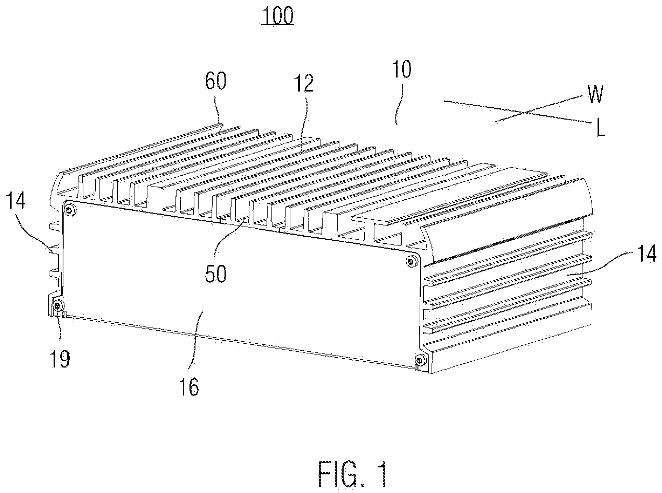

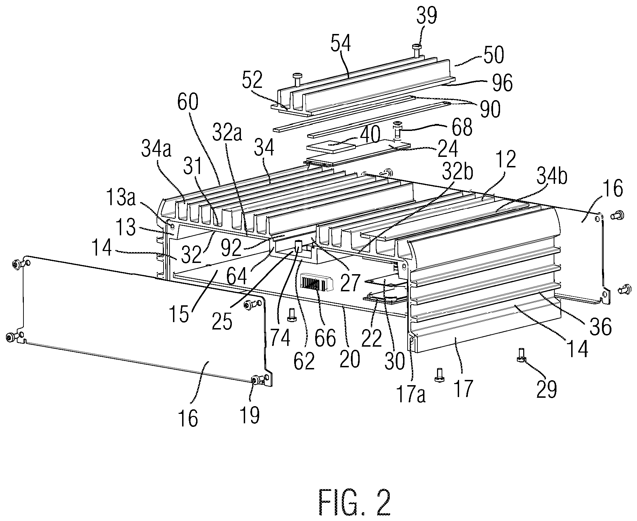

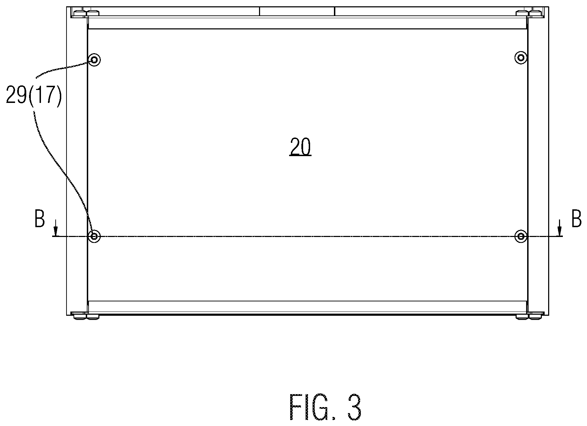

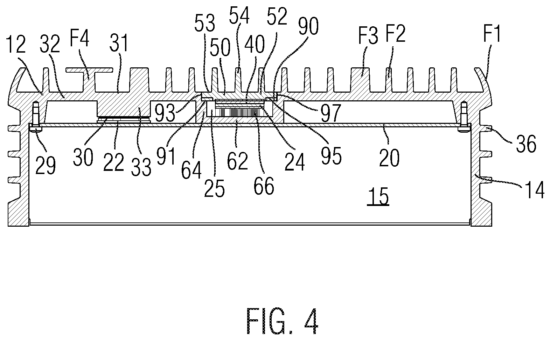

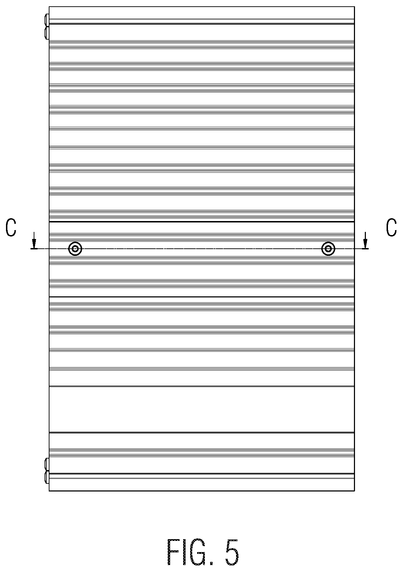

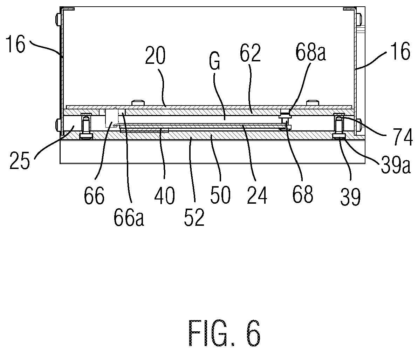

With reference to the drawings, where like numerals are used to designate like structure throughout the several views, an industrial personal computer (also referred to as "industrial PC" hereinafter) 100 according to an example embodiment of the present disclosure is shown. In the drawings, FIGS. 1 and 2 illustrate an assembled view and an exploded view of the industrial PC 100, respectively; FIGS. 3 and 5 are a bottom view and a top view of the industrial PC 100, respectively; and FIGS. 4 and 6 are cross-sectional views of the industrial PC 100 taken along a line B-B in FIG. 3 and a line C-C in FIG. 5, respectively.

As shown in FIGS. 1 and 2, generally, the industrial PC 100 comprises an integral main housing 10 and two lateral panels 16 (only one shown in FIGS. 1 and 2) attached to the main housing 10, which collectively define an interior for accommodating components necessary for functionalities of the industrial PC 100, including, but not limited to, electronic components, such as a motherboard 20, a CPU 22, a SSD 24 and etc. FIG. 1 illustrates an outer appearance of the industrial PC 100, and FIG. 2 shows the industrial PC 100 in an exploded view, in which only components associated with novel aspects of the disclosure are shown for simplicity purpose. Therefore, it should be understood that components which are not shown in FIG. 2 may be present in some embodiments of the disclosure and the components which are shown in FIG. 2 are not necessary to be present in all embodiments of the disclosure. A bottom panel may or may not be provided for the industrial PC 100 of the disclosure.

In particular, the main housing 10 comprises a top panel 12 and two side panels 14 extending from opposite ends of the top panel 12 in a longitudinal direction L, the top panel 12 and the two side panels 14 being integrally formed as shown in the drawings, or alternatively formed as separates parts and attached to each other, defining an inverted-U-shape profile when viewed in a lateral direction W perpendicular to the longitudinal direction L and defining an internal space 15. The two lateral panels 16 are attached to opposite side surfaces of the main housing 10 in the lateral direction W to define the interior.

Unless otherwise specified herein, the directional terms "lateral direction" and "longitudinal direction" are used to describe orthogonal directional components as shown in FIG. 1. Further, the terms "inward", "inwardly", "inner" and words of similar import and the terms "outward", "outwardly", "outer" and words of similar import refer to a direction from an ambient toward the internal space 15, and an opposite direction away from the internal space 15, respectively

According to a general principle of the disclosure, the industrial PC 100 provides two separate heat dissipating paths for two main heat generating components of the industrial PC 100, i.e. a CPU heat dissipating path for cooling the CPU 22 and a SSD heat dissipating path for cooling the SSD 24. The CPU heat dissipating path and the SSD heat dissipating path include a CPU heat dissipating member 60 and a SSD heat dissipating member 50 each exposed to ambient air, respectively, and are configured for dissipating heat generated by the CPU 22 and the SSD 24 into the ambient air independently and directly. Optionally, The CPU heat dissipating path and the SSD heat dissipating path further include a CPU heat transferring member 30 and a SSD heat transferring member 40 each configured for transferring the heat generated by the CPU 22 and the SSD 24 to the CPU heat dissipating member 60 and the SSD heat dissipating member 50, respectively.

In the disclosure, the integral main housing 10 acts as the CPU heat dissipating member 60 and the CPU heat dissipating member 60 defines the internal space 15 and constitutes a portion of the outer appearance of the industrial PC 100. However, in a condition that the top panel 12 and the side panels 14 are formed separately, the CPU heat dissipating member 60 may include only one or two of the panels, instead of all the three panels.

Advantageously, the SSD heat dissipating path is configured to be heat isolated from the CPU heat dissipating path in that, almost all components of the SSD heat dissipating path, especially the SSD heat dissipating member 50, are spaced apart from the components of the CPU heat dissipating path, especially the CPU heat dissipating member 60, with a gap or with a heat insulating member interposed between contacting surfaces of the SSD heat dissipating member 50 and the CPU heat dissipating member 60. As a result, effect of the CPU heat dissipating member 60, which has a much higher temperature than the ambient air and than the SSD heat dissipating member 50, on the SSD heat dissipating member 50, which has a relatively lower temperature compared to the CPU heat dissipating member 60, is eliminated or at least minimized. Moreover, the SSD 24, or at least a portion of the SSD 24, is positioned outside of the main housing 10 or the CPU heat dissipating member 60, which further facilitates the heat dissipation of the SSD 24.

To this end, a portion of the CPU heat dissipating member 60 or main housing 10 is recessed toward and into the internal space 15 to form a pocket 25, and the SSD heat dissipating member 50, the optional SSD heat transferring member 40 and at least a portion of the SSD 24 of the SSD heat dissipating path are situated in the pocket 25. As an example, the pocket 25 is formed in the top panel 12. Alternatively, it can be provided in any one of the side panels 14.

With regard to the CPU heat dissipating path, reference can be made to FIGS. 2 and 4. Within the internal space 15 is provided a motherboard 20, and the CPU 22 is secured to the motherboard 20 by surface mount technology, for example, or any other suitable technologies well known in the art. The manner of securing the motherboard 20 to the main housing 10 and the manner of securing the CPU 22 to the motherboard 20 are not emphasis of the disclosure, and only an example is illustrated in the drawings.

Specifically, as shown in FIG. 2, two bosses 13 extend inwardly into the internal space 15 from one or more panels of the main housing 10, and for example from jointing portions of the top panel 12 and the side panels 14 as shown. Two bosses 17 extend outwardly from one or more panels of the main housing 10, and for example from each of the side panels 14. Each of the lateral panels 16 can be secured to the two bosses 13 and the two bosses 17 with fasteners 19. Unless otherwise specifically indicated, the term "fastener" used in the disclosure can refer to a bolt, a screw, a rivet or any other suitable fastening element well known in the art. As shown in FIG. 2, holes 13a and 17a for the fasteners 19 are provided and extend into the corresponding bosses 13 and 17 in the lateral direction W. The motherboard 20 is also secured to bosses 13 by means of fasteners 29. For example, as shown in FIGS. 3 and 4, at each end of the motherboard 20 in the longitudinal direction L, the motherboard 20 is secured to the corresponding boss 13, at two positions 17 along a width of the boss 13 in the lateral direction W. Each of the bosses 13 can extend along an entire width of the main housing 10 or comprise several segments for securing the lateral panels 16 and the motherboard 20.

At a position where the CPU 22 is secured or fixed to the motherboard 20, a protrusion 33 (FIG. 4) is provided and extends inwardly from the top panel 12 toward the motherboard 20 to an extent so that, in the assembled state, the CPU heat transferring member 30 is sandwiched and compressed tightly between the CPU 22 and the protrusion 33 of the top panel 12, which is part of the CPU heat dissipating member 60, forming the CPU heat dissipating path. As such, a sufficient heat transfer from the CPU 22 to the CPU heat dissipating member 60 is ensured. It should be understood for a skilled in the art that the protrusion 33 may be omitted in some embodiments of disclosure as long as the sufficient heat transfer is ensured.

The CPU heat transferring member 30 can be made of a material with a high heat conductivity, and preferably, it is made of a heat conductive elastomer. In an embodiment, the CPU heat transferring member 30 is made of heat conductive silicon rubber so that, in the assembled industrial PC 100, the CPU heat transferring member 30 is compressed and deformed between the CPU 22 and the top panel 12. As such, surface bonding is provided between the CPU 22 and the CPU heat transferring member 30 and between the CPU heat transferring member 30 and the top panel 12. It should be understood that adopting the CPU heat transferring member 30 with elasticity is not the only way to transfer the heat generated by the CPU 22 to the main housing 10.

Also referring to FIG. 6 in combination, the SSD heat dissipating path will be described in detail, and in the illustrated embodiment, it is entirely situated in the pocket 25. In some embodiments, all components of the SSD heat dissipating path, including the SSD 24, the SSD heat transferring member 40 and the SSD heat dissipating member 50, are spaced apart from the main housing 10 by a gap to ensure that no heat exchange occurs therebetween. Alternatively, in this embodiment, a heat insulating member is interposed or provided between any component of the SSD heat dissipating path and an adjacent surface of the main housing 10 which will otherwise contact each other. The heat insulating member used in the context can be in a form of film or coating. Preferably, the heat insulating member is flexible, and a rigid heat insulating member is also contemplated. Possible materials that can be used for the heat insulating member include, but not limited to, glass fibre and asbestos.

As shown in the drawings, the pocket 25 extends along an entire width of the top panel 12 in the lateral direction W, opening at opposite ends in the lateral direction W. The pocket 25 further defines an opening 27 (FIG. 2) in a panel body 32 of the top panel 12, and comprises a bottom wall 62 and two side walls 64 opposite to each other for connecting the bottom wall 62 to the panel body 32 of the top panel 12.

As shown in FIG. 6, the SSD 24 in the pocket 25 is secured to the motherboard 20 in the internal space 15 by means of a SSD mount 66 which extends through a mount hole 66a formed in the bottom wall 62. Further, a fastener 68 is provided to pass through a fastener hole 68a formed in the bottom wall 62 to fasten the SSD 24 to the motherboard 20. Clearance fit is provided between the SSD mount 66 and the mount hole 66a and/or between the fastener 68 and the fastener hole 68a to minimize any possible heat transfer between the main housing 10 and the SSD 24. Any other suitable securing manner of the SSD 24 to the motherboard 20 can be contemplated.

Also in order to avoid any undesired heat transfer, a gap G (FIG. 6) is provided between the SSD 24 and the bottom wall 62 of the pocket 25. Alternatively or additionally, a heat insulating member can be provided between the SSD 24 and/or the SSD heat transferring member 40 and the bottom wall 62 and/or the side walls 64 of the pocket 25, as desired.

The SSD heat dissipating member 50 which is independent from the CPU heat dissipating member 60 or the main housing 10 can be located within the pocket 25 while being exposed to the ambient air. More advantageously, the SSD heat dissipating member 50 can be fitted in the opening 27 of the top panel 12 to cover it with their profiles complementary to each other, and preferably an outer surface 53 of a SSD body 52 of the SSD heat dissipating member 50 away from the internal space 15 can be flush or substantially flush with an outer surface 31 (FIG. 4) of the top panel 12, as shown in FIG. 4, which provides the industrial PC 100 with an aesthetically continuous and perfect appearance. That is to say, the SSD heat dissipating member 50 also forms a portion of the outer appearance of the industrial PC 100. The SSD body 52 of the SSD heat dissipating member 50 and the panel body 32 of the top panel 12 may have substantially the same thickness.

In some embodiments which are not shown in the drawings, in an assembled sate, the SSD body 52 of the SSD heat dissipating member 50 can be entirely spaced apart from the panel body 32 of the top panel 12 physically with a gap without any contacting points or surfaces therebetween. As an example, the SSD body 52 has the same shape as the opening 27 but has an outer dimension smaller than an inner dimension of the opening 27. As another example, the SSD body 52 is not co-planar with the panel body 32 to form a gap therebetween.

More generally and alternatively, in the embodiment as shown, there are some contacting points or surfaces between the SSD heat dissipating member 50 and the main housing 10 (in particular between the SSD heat dissipating member 50 and the portions of the top panel 12 defining the opening 27), but heat insulating members are provided between them at the contacting points or surfaces to space them apart from each other.

With reference to FIGS. 4 and 6, the SSD heat dissipating member 50 is shown in its assembled state, in which the SSD heat dissipating member 50 is secured to bottom wall 62 of the pocket 25, and its SSD body 52 is fitted in the opening 27 and coplanar with the panel body 32.

In particular, one or more studs 74 (two studs 74 shown in FIGS. 2 and 6) extend outwardly from the bottom wall 62 of the pocket 25 away from the internal wall 15, and fasteners 39 pass through holes 39a (counter bores as in FIG. 6) formed in the SSD heat dissipating member 50 into corresponding holes (not identified) formed in the studs 74, securing the SSD heat dissipating member 50 to the bottom wall 62 and thus to the top panel 12. The studs 74 are dimensioned so that, when the SSD heat dissipating member 50 is secured to the bottom wall 62 of the pocketing 25 of the top panel 12, the SSD heat transferring member 40 is compressed and deformed between the SSD 24 and the SSD heat dissipating member 50 so as to establish a good heat transfer from the SSD 24 to the SSD heat dissipating member 50. It is noted that the above description about the CPU heat transferring member 30 is also applied to the SSD heat transferring member 40.

The panel body 32 of the top panel 12 comprises concave corners 92 (FIG. 2) defining the opening 27, each of which is defined by a first corner surface 91 (FIG. 4) and a second corner surface 93 (FIG. 4) connected with each other, and the SSD body 52 of the SSD heat dissipating member 50 defines convex edges 96 (FIG. 2) each of which is adapted to be mated with the concave corner 92 and defined by a first edge surface 95 (FIG. 4) to be pressed against the first corner surface 91 and a second edge surface 97 (FIG. 4) to face the second corner surface 93.

A heat insulating member 90 is provided between the first edge surface 95 and the first corner surface 91 which otherwise will contact each other. The second edge surface 97 and the second corner surface 95 can be spaced apart from each other, or can be provided with another heat insulating member therebetween. According to actual demands, the concave corner 92 can be a right-angled or rounded corner and the convex edge 96 can be a right-angled or rounded edge accordingly.

With the structure shown and described as above, the SSD heat dissipating member 50 is heat isolated from the CPU heat dissipating member or main housing 10, and the object of eliminating or minimizing the effect of CPU heat dissipation on SSD heat dissipation and thus improving heat dissipating efficiency and cooling effect of the SSD is achieved.

As the heat dissipating members in the industrial PC 100, both the main housing 10 and the SSD heat dissipating member 50 can be made of aluminum or any suitable materials well known in the art. In addition, it can also be seen from the drawings that all these heat dissipating members are provided with heat dissipating fins extending outwardly into the ambient air so as to increase a surface area for heat dissipation. In this regard, the SSD heat dissipating member 50 has a general similar structure as the CPU heat dissipating member 60.

Typically, the main housing 10 as the CPU heat dissipating member 60 comprises CPU (heat dissipating) fins, including CPU top fins 34 extending outwardly from the panel body 32 and CPU side fins 36 on the side panels 14 extending outwardly. Due to the presence of the pocket 25, the panel body 32 of the top panel 12 is divided into a first portion 32a and a second portion 32b and the CPU top fins 34 are divided into a fist set of top fins 34a of the first portion 32a and a second set of top fins 34b of the second portion 32b. Similarly, the SSD heat dissipating member 50 comprises SSD (heat dissipating) fins 54 extending from the SSD body 52 outwardly. The first set of top fins 34a and the second set of top fins 34b can be symmetrical or asymmetrical (as shown) with regard to the opening 27 of the pocket 25.

Each of the CPU top fins 34, the side fins 36 and the SSD fins 54 may have different types of fins. The types of fins are associated with parameters of fins, including, but not limited to, an extending direction of fins, the number of fins, a cross-sectional shape of fins, a cross-sectional dimension of fins, periodicity of fins arrangement; and a spacing between adjacent fins etc. As an example, in the illustrated embodiment, four types of fins are shown for the CPU top fins 34, a first type of fins F1, a second type of fins F2, a third type of fins F3 and a fourth type of fins F4. Fins can extend linearly as shown or curvedly in their extending directions parallel to the lateral direction W. Examples of possible cross-sectional shapes of fins in a plane perpendicular to the extending direction of the fin include, but not limited to, rectangular, triangular, trapezoidal and curved. It can be understood that the structure about the heat dissipating fins is not limited to the details shown in the drawings.

The embodiment of the industrial PC shown in the drawing has been described as an example mode known to the skilled in the art for carrying out the disclosure. Providing the industrial PC with separate heat dissipating paths for the CPU and the SSD with the CPU heat dissipating member and the SSD heat dissipating member both exposed to the ambient air, the heat generated by the CPU and the SSD can be dissipated into the ambient air independently and directly. The fact that the two heat dissipating paths, in particular the CPU heat dissipating member and the SSD heat dissipating member, are heat isolated from each other eliminates or at least minimizes the effect of the CPU heat dissipation on the SSD heat dissipation and thus substantially improves the cooling effect of the SSD. The fact that the SSD heat dissipating member is shaped to be complementary to the opening in the CPU heat dissipating member with their outer surfaces flush with each other and, preferably, the heat dissipating fins of the CPU heat dissipating member and those of the SSD heat dissipating member are arranged in a desired pattern provides the industrial PC with aesthetically ideal appearance.

Upon reading the foregoing description, variations of the embodiment may become apparent to those of ordinary skill in the art. Some possible modifications have been contemplated.

For example, opposed to providing the pocket with opposite ends in the lateral direction W, the pocket for receiving the components of the SSD heat dissipating path can be formed as a closed opening, and the concave corner 92 and the convex edge 96 can extend entirely around the opening. The opening may have any suitable shape, and for example, the opening, as well as the SSD heat dissipating member, may be polygonal, such as triangular, rectangular, trapezoidal, pentagonal, hexagonal, quadrilateral or octagonal, or oval, or circular. In some embodiments, It can be contemplated that, different from the pocket defined by the planar bottom wall and the planar side walls as shown, it can be defined by one or more curved walls.

For example, instead of being secured to the bottom wall of the pocket, the SSD heat dissipating member can be secured to the side walls of the pocket, or to both the bottom wall and the side walls. It is also contemplated that the SSD heat dissipating member can be secured to any accessory fixed to the SSD, or can be secured to the motherboard similar to the SSD. As an example, a connecting member and/or a fastener extend through the bottom wall of the pocket to secure the SSD heat dissipating member to the motherboard. Any other arrangements for securing the SSD heat dissipating member can be designed under the premise of substantially no heat exchange between the SSD heat dissipating member and the CPU heat dissipating member.

Further, the manner of securing the SSD is not limited that described above. The SSD can be secured to a motherboard, for example by means of one or both of the SSD mount and the fastener extending through the bottom wall or any other portion of the pocket, and the mount hole for SSD mount and the fastener hole for the fastener can be provided as separates holes or a single hole which is sized to receive both of them. Alternatively, a single hole can be provided to receive a portion of the SSD. It is also contemplated that the SSD is entirely accommodated in and secured to the pocket. For example, the SSD can be secured to the bottom wall and/or the side walls of the pocket, with one or more electrically connecting members extending through the pocket to electrically connect the SSD to an electronic component on the motherboard.

In some embodiments, for example the one shown in the drawings, the top panel 12 and the side panels 24 are formed as an integral component, the whole main housing 10 functions as the CPU heat dissipating member, and the pocket in which the SSD heat dissipating member is situated can be provided in any of these panels. However, in some embodiments where the top panel 12 and the side panels 24 of the main housing 10 are formed as separate parts, the CPU heat dissipating member can include only one or two panels of the top panel 12 and the side panels 24.

It will be appreciated that the use of the terms "a", "an", "the" and similar referents in the context of describing the disclosure (especially in the context of the following claims) is to be construed to cover both the singular and the plural, unless otherwise indicated herein or clearly contradicted by context. The terms "comprising", "having", and "including" are to be construed as open-ended terms (i.e., meaning "including, but not limited to,") unless otherwise noted. The use of exemplary language (e.g., "such as") is intended merely to better illuminate the disclosure and does not pose a limitation on the scope of the invention unless otherwise claimed. No language in the specification should be construed as indicating any non-claimed element as essential to the practice of the invention.

It will be further appreciated that terms such as "first", "second", "third", and the like are used herein to differentiate certain structural features and components for the nonlimiting, illustrative purposes of clarity and consistency.

The example configuration and several alternatives have been discussed in the foregoing description. However, the configurations discussed herein are not intended to be exhaustive or limit the invention to any particular form. The terminology which has been used is intended to be in the nature of words of description rather than of limitation.

## Claims

1. An industrial personal computer (100) comprising:
a main housing (10) exposed to ambient air and comprising a top panel (12) and two side panels (14), the two side panels (14) extending from opposite ends of the top panel (12) in a longitudinal direction (L) to define an inverted-U-shape profile when viewed in a lateral direction (W) perpendicular to the longitudinal direction (L) and define an internal space (15), at least one panel of the top panel (12) and two side panels (14) being used as a CPU heat dissipating member (60), and a portion of the one panel being recessed into the internal space (15) to form a pocket (25);
a CPU (22) accommodated in the internal space (15), heat generated by the CPU (22) being transferred to the CPU heat dissipating member (60) in a CPU heat dissipating path and dissipated directly into the ambient air from the CPU heat dissipating member (60);
a SSD (24) at least partially positioned in the pocket (25); and
a SSD heat dissipating member (50) positioned in the pocket (25) and exposed to the ambient air, heat generated by the SSD (24) being transferred to the SSD heat dissipating member (50) in a SSD heat dissipating path and dissipated directly into the ambient air from the SSD heat dissipating member (50),
wherein the SSD heat dissipating member (50) is heat isolated from the CPU heat dissipating member (60), wherein the SSD heat dissipating member (50) is spaced apart from the CPU heat dissipating member (60) with a gap, or the SSD heat dissipating member (50) and the CPU heat dissipating member (60) comprise surfaces contacting each other with a heat insulating member (90) interposed between the surfaces and heat isolating them from each other,
wherein the one panel comprises a panel body, the pocket (25) defining an opening (27) in the panel body of the one panel, and the SSD heat dissipating member (50) being configured to cover the opening (27).

2. The industrial personal computer (100) according to claim 1, wherein the SSD heat dissipating member (50) comprises a SSD body (52) which is shaped to be complementary to the opening (27).

3. The industrial personal computer (100) according to claim 2, wherein an outer surface (53) of the SSD body (52) of the SSD heat dissipating member (50) away from the internal space (15) is flush with is an outer surface (31) of the panel body away from the internal space (15).

4. The industrial personal computer (100) according to claim 2, wherein the panel body defines a concave corner (92) extending along the opening (27) and defined by a first corner surface (91) and a second corner surface (93) connected with each other, and the SSD body (52) of the SSD heat dissipating member (50) defines a convex edge (96) adapted to be mated with the concave corner (92) and defined by a first edge surface (95) to be pressed against the first corner surface (91) and a second edge surface (97) to face the second corner surface (93),
wherein the heat insulating member (90) is preferably provided between the first edge surface (95) and the first corner surface (91) and the second edge surface (97) and the second corner surface (93) are spaced apart from each other, or
the heat insulating member (90) is preferably provided between the first edge surface (95) and the first corner surface (91) and between the second edge surface (97) and the second corner surface (93), or
wherein the concave corner (92) is preferably a right-angled or rounded corner and the convex edge (96) is preferably right-angle right-angled or rounded edge.

5. The industrial personal computer (100) according to any one claims 2 - 4, wherein the opening (27) extends along an entire width of the one panel in the lateral direction (W) and opens at opposite ends in the lateral direction (W), or
the opening (27) is a closed opening and is shaped to be trapezoidal, triangular, pentagonal, hexagonal rectangular, octagonal, oval, or circular.

6. The industrial personal computer (100) according to any one of claims 2-5, wherein the heat insulating member (90) is in a form of film or coating, and the heat insulating member (90) is made of glass fiber or asbestos.

7. The industrial personal computer (100) according to any one of claims 2-6, wherein the opening (27) extends along an entire width of the one panel in the lateral direction (W) and divides CPU top fins extending outwardly from the one panel away from the internal space (15) into a first set of fins and a second set of fins, and the SSD heat dissipating member (50) comprises SSD fins extending outwardly away from the internal space (15), and wherein
the first set of fins and the second set of fins are symmetrical or asymmetrical with regard to the opening (27); and/or
the CPU top fins and/or the SSD fins each include one or more types of fins, the type of fin being associated with parameters of the fin including an extending direction of the fin, a cross-sectional shape of the fin, a cross-sectional dimension of the fin, a spacing between adjacent fins, and the arrangement pattern of the fins.

8. The industrial personal computer (100) any one of claims 1-7, further comprising a motherboard (20) which is secured to the main housing (10) within the internal space (15), the CPU (22) being secured to the motherboard (20), and the motherboard (20) being spaced apart from or in contact with a bottom wall (62) of the pocket (25) closest to the motherboard (20).

9. The industrial personal computer (100) according to claim 8, wherein
the SSD (24) is secured to a motherboard (20) by means of at least one of a SSD mount (66) which extends through a mount hole (66a) formed in the bottom wall (62) of the pocket (25) and a fastener (68) which extends through a fastener hole (68a) formed in the bottom wall (62), the mount hole (66a) and the fastener hole (68a) being provided as separates holes or a single hole which is sized to receive both the SSD mount (66) and the fastener (68) or to receive at least a portion of the SSD (24); or
the SSD (24) is entirely accommodated in and secured to the pocket (25) with an electrically connecting member extending through the pocket (25) to electrically connect the SSD (24) to an electronic component on the motherboard (20),
wherein the SSD (24) and a surface of the pocket (25) adjacent to the SSD (24) are preferably heat isolated from each other by a further heat insulating member interposed therebetween or by a gap (G) separating them apart from each other.

10. The industrial personal computer (100) according to any one of claims 8-9, wherein the SSD heat dissipating member (50) is secured to an intermediate component which in turn is secured to the SSD (24), or the SSD heat dissipating member (50) is secured to the motherboard (20) with a connecting member which extends through the pocket (25).

11. The industrial personal computer (100) according to any one of claims 8-9, wherein the SSD heat dissipating member (50) is secured to the CPU heat dissipating member (60).

12. The industrial personal computer (100) according to claim 11, wherein the SSD heat dissipating member (50) is secured to the bottom wall (62) and/or a side wall of the pocket (25) connecting the bottom wall (62) with a panel body of the one panel.

13. The industrial personal computer (100) according to claim 12, wherein one or more studs extend from the bottom wall (62), and the SSD heat dissipating member (50) being secured to the studs with a fastener.

14. The industrial personal computer (100) according to any one of claims 1-13, wherein the CPU heat dissipating path further comprises a CPU heat transferring member (30) which is configured to be sandwiched and compressed between the CPU (22) and the main housing (10) so as to transfer the heat from the CPU (22) to the main housing (10); and
the SSD heat dissipating path further comprising a SSD heat transferring member (40) which is configured to be sandwiched and compressed between the SSD (24) and the SSD heat dissipating member (50) so as to transfer the heat from the SSD (24) to the SSD heat dissipating member (50),
wherein the SSD heat transferring member (40) and the CPU heat transferring member (30) are made of heat conductive elastomer.

15. The industrial personal computer (100) according to any one of claims 1-14, wherein the one panel is the top panel (12), the panel (12) and two side panels (14) are formed as an integral or formed separately and attached to each other, and the entire main housing (10) is used as the CPU heat dissipating member (60).

## Patentansprüche

1. Industrie-Personalcomputer (100), der Folgendes umfasst:
ein Hauptgehäuse (10), das Umgebungsluft ausgesetzt ist und eine obere Platte (12) und zwei Seitenplatten (14) umfasst, wobei sich die zwei Seitenplatten (14) von gegenüberliegenden Enden der oberen Platte (12) so in einer Längsrichtung (L) erstrecken, dass sie bei Ansicht in einer lateralen Richtung (W) senkrecht zur Längsrichtung (L) ein umgekehrtes U-Profil definieren und einen Innenraum (15) definieren, wobei mindestens eine Platte der oberen Platte (12) und der zwei Seitenplatten (14) als ein CPU-Wärmeableitelement (60) verwendet wird und ein Abschnitt der einen Platte so in den Innenraum (15) zurückgesetzt ist, dass er eine Tasche (25) bildet;
eine CPU (22), die in dem Innenraum (15) aufgenommen ist, wobei durch die CPU (22) erzeugte Wärme in einem CPU-Wärmeableitungspfad auf das CPU-Wärmeableitelement (60) übertragen wird und von dem CPU-Wärmeableitelement (60) direkt in die Umgebungsluft abgeleitet wird;
eine SSD (24), die zumindest teilweise in der Tasche (25) positioniert ist; und
ein SSD-Wärmeableitelement (50), das in der Tasche (25) positioniert und der Umgebungsluft ausgesetzt ist, wobei durch die SSD (24) erzeugte Wärme in einem SSD-Wärmeableitungspfad auf das SSD-Wärmeableitelement (50) übertragen und von dem SSD-Wärmeableitelement (50) direkt in die Umgebungsluft abgeleitet wird,
wobei das SSD-Wärmeableitelement (50) von dem CPU-Wärmeableitelement (60) wärmeisoliert ist, wobei das SSD-Wärmeableitelement (50) mit einem Spalt von dem CPU-Wärmeableitelement (60) beabstandet ist oder das SSD-Wärmeableitelement (50) und das CPU-Wärmeableitelement (60) miteinander in Kontakt stehende Oberflächen umfassen, wobei ein Wärmeisolierelement (90) zwischen den Oberflächen angeordnet ist und diese voneinander wärmeisoliert,
wobei die eine Platte einen Plattenkörper umfasst, wobei die Tasche (25) eine Öffnung (27) in dem Plattenkörper der einen Platte definiert und das SSD-Wärmeableitelement (50) dazu ausgelegt ist, die Öffnung (27) abzudecken.

2. Industrie-Personalcomputer (100) nach Anspruch 1, wobei das SSD-Wärmeableitelement (50) einen SSD-Körper (52) umfasst, der komplementär zu der Öffnung (27) geformt ist.

3. Industrie-Personalcomputer (100) nach Anspruch 2, wobei eine von dem Innenraum (15) entfernte Außenfläche (53) des SSD-Körpers (52) des SSD-Wärmeableitelements (50) mit einer von dem Innenraum (15) entfernten Außenfläche (31) des Plattenkörpers bündig ist.

4. Industrie-Personalcomputer (100) nach Anspruch 2, wobei der Plattenkörper eine konkave Ecke (92) definiert, die sich entlang der Öffnung (27) erstreckt und durch eine erste Eckfläche (91) und eine zweite Eckfläche (93) definiert ist, die miteinander verbunden sind, und wobei der SSD-Körper (52) des SSD-Wärmeableitelements (50) eine konvexe Kante (96) definiert, die dazu geeignet ist, mit der konkaven Ecke (92) zusammengefügt zu sein, und durch eine gegen die erste Eckfläche (91) zu drückende erste Kantenfläche (95) und eine der zweiten Eckfläche (93) zugewandte zweite Kantenfläche (97) definiert ist,
wobei das Wärmeisolierelement (90) vorzugsweise zwischen der ersten Kantenfläche (95) und der ersten Eckfläche (91) bereitgestellt ist und die zweite Kantenfläche (97) und die zweite Eckfläche (93) voneinander beabstandet sind, oder
wobei das Wärmeisolierelement (90) vorzugsweise zwischen der ersten Kantenfläche (95) und der ersten Eckfläche (91) und zwischen der zweiten Kantenfläche (97) und der zweiten Eckfläche (93) bereitgestellt ist, oder
wobei die konkave Ecke (92) vorzugsweise eine rechtwinklige oder abgerundete Ecke ist und die konvexe Kante (96) vorzugsweise ein rechter Winkel, eine rechtwinklige oder eine abgerundete Kante ist.

5. Industrie-Personalcomputer (100) nach einem der Ansprüche 2-4, wobei sich die Öffnung (27) in der lateralen Richtung (W) entlang einer gesamten Breite der einen Platte erstreckt und sich in der lateralen Richtung (W) an gegenüberliegenden Enden öffnet, oder
wobei die Öffnung (27) eine geschlossene Öffnung ist und trapezförmig, dreieckig, fünfeckig, sechseckig, rechteckig, achteckig, oval oder kreisförmig geformt ist.

6. Industrie-Personalcomputer (100) nach einem der Ansprüche 2-5, wobei das Wärmeisolierelement (90) in einer Form von Folie oder Beschichtung vorliegt und das Wärmeisolierelement (90) aus Glasfaser oder Asbest besteht.

7. Industrie-Personalcomputer (100) nach einem der Ansprüche 2-6, wobei sich die Öffnung (27) in der lateralen Richtung (W) entlang einer gesamten Breite der einen Platte erstreckt und obere CPU-Rippen, die sich von der einen Platte von dem Innenraum (15) weg nach außen erstrecken, in einen ersten Satz von Rippen und einen zweiten Satz von Rippen unterteilt, und wobei das SSD-Wärmeableitelement (50) SSD-Rippen umfasst, die sich von dem Innenraum (15) weg nach außen erstrecken, und wobei
der erste Satz von Rippen und der zweite Satz von Rippen in Bezug auf die Öffnung (27) symmetrisch oder asymmetrisch sind; und/oder
die oberen CPU-Rippen und/oder die SSD-Rippen jeweils eine oder mehrere Arten von Rippen umfassen, wobei die Art der Rippe mit Parametern der Rippe assoziiert ist, die eine Erstreckungsrichtung der Rippe, eine Querschnittsform der Rippe, eine Querschnittsabmessung der Rippe, einen Abstand zwischen benachbarten Rippen und das Anordnungsmuster der Rippen umfassen.

8. Industrie-Personalcomputer (100) nach einem der Ansprüche 1-7, ferner umfassend eine Hauptplatine (20), die an dem Hauptgehäuse (10) innerhalb des Innenraums (15) gesichert ist, wobei die CPU (22) an der Hauptplatine (20) gesichert ist und die Hauptplatine (20) von einer unteren Wand (62) der Tasche (25), die der Hauptplatine (20) am nächsten liegt, beabstandet ist oder mit dieser in Kontakt steht.

9. Industrie-Personalcomputer (100) nach Anspruch 8, wobei
die SSD (24) mittels einer SSD-Halterung (66), die sich durch ein in der unteren Wand (62) der Tasche (25) gebildetes Halterungsloch (66a) erstreckt, und/oder eines Befestigungselements (68), das sich durch ein in der unteren Wand (62) gebildetes Befestigungselementloch (68a) erstreckt, an einer Hauptplatine (20) gesichert ist, wobei das Halterungsloch (66a) und das Befestigungselementloch (68a) als separate Löcher oder ein einzelnes Loch bereitgestellt sind, das so dimensioniert ist, dass es sowohl die SSD-Halterung (66) als auch das Befestigungselement (68) aufnimmt oder zumindest einen Teil der SSD (24) aufnimmt; oder
die SSD (24) vollständig in der Tasche (25) aufgenommen und an dieser gesichert ist, wobei sich ein elektrisches Verbindungselement durch die Tasche (25) erstreckt, um die SSD (24) elektrisch mit einer elektronischen Komponente auf der Hauptplatine (20) zu verbinden,
wobei die SSD (24) und eine an die SSD (24) angrenzende Oberfläche der Tasche (25) vorzugsweise durch ein dazwischen angeordnetes weiteres Wärmeisolierelement oder durch einen sie voneinander trennenden Spalt (G) voneinander wärmeisoliert sind.

10. Industrie-Personalcomputer (100) nach einem der Ansprüche 8-9, wobei das SSD-Wärmeableitelement (50) an einer dazwischen liegenden Komponente gesichert ist, die wiederum an der SSD (24) gesichert ist, oder das SSD-Wärmeableitelement (50) mit einem Verbindungselement an der Hauptplatine (20) gesichert ist, das sich durch die Tasche (25) erstreckt.

11. Industrie-Personalcomputer (100) nach einem der Ansprüche 8-9, wobei das SSD-Wärmeableitelement (50) an dem CPU-Wärmeableitelement (60) gesichert ist.

12. Industrie-Personalcomputer (100) nach Anspruch 11, wobei das SSD-Wärmeableitelement (50) an der unteren Wand (62) und/oder einer Seitenwand der Tasche (25) gesichert ist, die die unteren Wand (62) mit einem Plattenkörper der einen Platte verbindet.

13. Industrie-Personalcomputer (100) nach Anspruch 12, wobei sich ein oder mehrere Bolzen von der unteren Wand (62) erstrecken und das SSD-Wärmeableitelement (50) mit einem Befestigungselement an den Bolzen gesichert ist.

14. Industrie-Personalcomputer (100) nach einem der Ansprüche 1-13, wobei der CPU-Wärmeableitungspfad ferner ein CPU-Wärmeübertragungselement (30) umfasst, das dazu ausgelegt ist, zwischen der CPU (22) und dem Hauptgehäuse (10) sandwichartig angeordnet und komprimiert zu sein, um die Wärme von der CPU (22) auf das Hauptgehäuse (10) zu übertragen; und
wobei der SSD-Wärmeableitungspfad ferner ein SSD-Wärmeübertragungselement (40) umfasst, das dazu ausgelegt ist, zwischen der SSD (24) und dem SSD-Wärmeableitelement (50) sandwichartig angeordnet und komprimiert zu sein, um die Wärme von der SSD (24) auf das SSD-Wärmeableitelement (50) zu übertragen,
wobei das SSD-Wärmeübertragungselement (40) und das CPU-Wärmeübertragungselement (30) aus wärmeleitfähigem Elastomer bestehen.

15. Industrie-Personalcomputer (100) nach einem der Ansprüche 1-14, wobei die eine Platte die obere Platte (12) ist, wobei die Platte (12) und zwei Seitenplatten (14) integral ausgebildet oder separat ausgebildet und aneinander angebracht sind und das gesamte Hauptgehäuse (10) als das CPU-Wärmeableitelement (60) verwendet wird.

## Revendications

1. Ordinateur personnel industriel (100) comprenant :
un logement principal (10) exposé à l'air ambiant et comprenant un panneau supérieur (12) et deux panneaux latéraux (14), les deux panneaux latéraux (14) s'étendant à partir d'extrémités opposées du panneau supérieur (12) dans une direction longitudinale (L) pour définir un profil en conformation de U renversé lorsque vu dans une direction latérale (W) perpendiculaire à la direction longitudinale (L) et définir un espace interne (15), au moins un panneau parmi le panneau supérieur (12) et les deux panneaux latéraux (14) étant utilisé comme élément de dissipation thermique de CPU (60), et une partie de ce panneau étant encastrée dans l'espace interne (15) pour former une poche (25) ;
une CPU (22) accueillie dans l'espace interne (15), la chaleur générée par la CPU (22) étant transférée à l'élément de dissipation thermique de CPU (60) dans un chemin de dissipation thermique de CPU et dissipée directement dans l'air ambiant à partir de l'élément de dissipation thermique de CPU (60) ;
un SSD (24) au moins partiellement positionné dans la poche (25) ; et
un élément de dissipation thermique de SSD (50) positionné dans la poche (25) et exposé à l'air ambiant, la chaleur générée par le SSD (24) étant transférée à l'élément de dissipation thermique de SSD (50) dans un chemin de dissipation thermique de SSD et dissipée directement dans l'air ambiant à partir de l'élément de dissipation thermique de SSD (50),
dans lequel l'élément de dissipation thermique de SSD (50) est isolé thermiquement de l'élément de dissipation thermique de CPU (60), l'élément de dissipation thermique de SSD (50) étant espacé de l'élément de dissipation de thermique de CPU (60) avec un intervalle, ou l'élément de dissipation thermique de SSD (50) et l'élément de dissipation thermique de CPU (60) comprenant des surfaces en contact l'une avec l'autre avec un élément d'isolation thermique (90) interposé entre les surfaces et les isolant thermiquement l'une de l'autre,
dans lequel le panneau comprend un corps de panneau, la poche (25) définissant une ouverture (27) dans le corps de panneau du panneau, et l'élément de dissipation thermique de SSD (50) étant configuré pour couvrir l'ouverture (27).

2. Ordinateur personnel industriel (100) selon la revendication 1, dans lequel l'élément de dissipation thermique de SSD (50) comprend un corps de SSD (52) qui est conformé pour être complémentaire à l'ouverture (27).

3. Ordinateur personnel industriel (100) selon la revendication 2, dans lequel une surface extérieure (53) du corps de SSD (52) de l'élément de dissipation thermique de SSD (50) à l'écart de l'espace interne (15) est alignée avec une surface extérieure (31) du corps de panneau à l'écart de l'espace interne (15).

4. Ordinateur personnel industriel (100) selon la revendication 2, dans lequel le corps de panneau définit un coin concave (92) s'étendant le long de l'ouverture (27) et défini par une première surface de coin (91) et une seconde surface de coin (93) connectées l'une à l'autre, et le corps de SSD (52) de l'élément de dissipation thermique de SSD (50) définit un bord convexe (96) conçu pour être apparié avec le coin concave (92) et défini par une première surface de bord (95) à presser contre la première surface de coin (91) et une seconde surface de bord (97) pour faire face à la seconde surface de coin (93),
dans lequel l'élément d'isolation thermique (90) est de préférence fourni entre la première surface de bord (95) et la première surface de coin (91) et la seconde surface de bord (97) et la seconde surface de coin (93) sont espacées l'une de l'autre, ou
l'élément d'isolation thermique (90) est de préférence fourni entre la première surface de bord (95) et la première surface de coin (91) et entre la seconde surface de bord (97) et la seconde surface de coin (93), ou
dans lequel le coin concave (92) est de préférence un coin à angle droit ou arrondi et le bord convexe (96) est de préférence un bord à angle droit ou arrondi.

5. Ordinateur personnel industriel (100) selon l'une quelconque des revendications 2 à 4, dans lequel l'ouverture (27) s'étend le long d'une largeur entière du panneau dans la direction latérale (W) et s'ouvre au niveau d'extrémités opposées dans la direction latérale (W), ou
l'ouverture (27) est une ouverture fermée et est conformée pour être trapézoïdale, triangulaire, pentagonale, hexagonale rectangulaire, octogonale, ovale, ou circulaire.

6. Ordinateur personnel industriel (100) selon l'une quelconque des revendications 2 à 5, dans lequel l'élément d'isolation thermique (90) est sous une forme de film ou de revêtement, et l'élément d'isolation thermique (90) est fait de fibre de verre ou d'amiante.

7. Ordinateur personnel industriel (100) selon l'une quelconque des revendications 2 à 6, dans lequel l'ouverture (27) s'étend le long d'une largeur entière du panneau dans la direction latérale (W) et divise des ailettes supérieures de CPU s'étendant vers l'extérieur à partir du panneau à l'écart de l'espace interne (15) en un premier ensemble d'ailettes et un second ensemble d'ailettes, et dans lequel l'élément de dissipation thermique de SSD (50) comprend des ailettes de SSD s'étendant vers l'extérieur à l'écart de l'espace interne (15), et dans lequel
le premier ensemble d'ailettes et le second ensemble d'ailettes sont symétriques ou asymétriques par rapport à l'ouverture (27) ; et/ou
les ailettes supérieures de CPU et/ou les ailettes de SSD incluent chacune un ou plusieurs types d'ailettes, le type d'ailette étant associé à des paramètres de l'ailette incluant une direction d'extension de l'ailette, une conformation de section transversale de l'ailette, une dimension de section transversale de l'ailette, un espacement entre les ailettes adjacentes, et le motif d'agencement des ailettes.

8. Ordinateur personnel industriel (100) selon l'une quelconque des revendications 1 à 7, comprenant en outre une carte mère (20) qui est assujettie au logement principal (10) à l'intérieur de l'espace interne (15), la CPU (22) étant assujettie à la carte mère (20), et la carte mère (20) étant espacée de ou en contact avec une paroi inférieure (62) de la poche (25) la plus proche de la carte mère (20).

9. Ordinateur personnel industriel (100) selon la revendication 8, dans lequel
le SSD (24) est assujetti à une carte mère (20) au moyen d'au moins un élément parmi un dispositif de montage de SSD (66) qui s'étend à travers un trou de dispositif de montage (66a) formé dans la paroi inférieure (62) de la poche (25) et d'un dispositif de fixation (68) qui s'étend à travers un trou de dispositif de fixation (68a) formé dans la paroi inférieure (62), le trou de dispositif de montage (66a) et le trou de dispositif de fixation (68a) étant fournis comme trous séparés ou un trou unique qui est dimensionné pour recevoir à la fois le dispositif de montage de SSD (66) et le dispositif de fixation (68) ou pour recevoir au moins une partie du SSD (24) ; ou
le SSD (24) est entièrement accueilli dans et assujetti à la poche (25) avec un élément de connexion électrique s'étendant à travers la poche (25) pour connecter électriquement le SSD (24) à un composant électronique sur la carte mère (20),
dans lequel le SSD (24) et une surface de la poche (25) adjacente au SSD (24) sont de préférence isolés thermiquement l'un de l'autre par un élément d'isolation thermique supplémentaire interposé entre eux ou par un intervalle (G) les séparant l'un de l'autre.

10. Ordinateur personnel industriel (100) selon l'une quelconque des revendications 8 à 9, dans lequel l'élément de dissipation thermique de SSD (50) est assujetti à un composant intermédiaire qui à son tour est assujetti au SSD (24), ou l'élément de dissipation thermique de SSD (50) est assujetti à la carte mère (20) avec un élément de connexion qui s'étend à travers la poche (25).

11. Ordinateur personnel industriel (100) selon l'une quelconque des revendications 8 à 9, dans lequel l'élément de dissipation thermique de SSD (50) est assujetti à l'élément de dissipation thermique de CPU (60).

12. Ordinateur personnel industriel (100) selon la revendication 11, dans lequel l'élément de dissipation thermique de SSD (50) est assujetti à la paroi inférieure (62) et/ou à une paroi latérale de la poche (25) connectant la paroi inférieure (62) à un corps de panneau du panneau.

13. Ordinateur personnel industriel (100) selon la revendication 12, dans lequel un ou plusieurs goujons s'étendent à partir de la paroi inférieure (62), et l'élément de dissipation thermique de SSD (50) est assujetti aux goujons avec un dispositif de fixation.

14. Ordinateur personnel industriel (100) selon l'une quelconque des revendications 1 à 13, dans lequel le chemin de dissipation thermique de CPU comprend en outre un élément de transfert thermique de CPU (30) qui est configuré pour être pris en sandwich et comprimé entre la CPU (22) et le logement principal (10) de manière à transférer la chaleur de la CPU (22) au logement principal (10) ; et
le chemin de dissipation thermique de SSD comprenant en outre un élément de transfert thermique de SSD (40) qui est configuré pour être pris en sandwich et comprimé entre le SSD (24) et l'élément de dissipation thermique de SSD (50) de manière à transférer la chaleur du SSD (24) à l'élément de dissipation thermique de SSD (50),
dans lequel l'élément de transfert thermique de SSD (40) et l'élément de transfert thermique de CPU (30) sont faits d'un élastomère conducteur thermique.

15. Ordinateur personnel industriel (100) selon l'une quelconque des revendications 1 à 14, dans lequel l'un des panneaux est le panneau supérieur (12), le panneau (12) et deux panneaux latéraux (14) sont formés d'un seul tenant ou formés séparément et attachés l'un à l'autre, et le logement principal (10) entier est utilisé comme élément de dissipation thermique de CPU (60).
